(19) Europäisches Patentamt
European Patent Office
Office européen des brevets

(11) **EP 2 432 022 A1**

(12) **EUROPEAN PATENT APPLICATION**
published in accordance with Art. 153(4) EPC

(43) Date of publication:
**21.03.2012 Bulletin 2012/12**

(51) Int Cl.:
*H01L 29/739* (2006.01)    *H01L 21/02* (2006.01)
*H01L 21/20* (2006.01)    *H01L 21/336* (2006.01)
*H01L 29/12* (2006.01)    *H01L 29/78* (2006.01)

(21) Application number: **10774831.1**

(22) Date of filing: **27.04.2010**

(86) International application number:
**PCT/JP2010/057445**

(87) International publication number:
**WO 2010/131573 (18.11.2010 Gazette 2010/46)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **11.05.2009   JP 2009114737**
**24.09.2009   JP 2009219065**
**01.10.2009   JP 2009229764**
**29.10.2009   JP 2009248621**

(71) Applicant: **Sumitomo Electric Industries, Ltd.**
**Osaka-shi, Osaka 541-0041 (JP)**

(72) Inventors:
- **WADA, Keiji**
 **Osaka-shi**
 **Osaka 554-0024 (JP)**
- **HARADA, Shin**
 **Osaka-shi**
 **Osaka 554-0024 (JP)**
- **MASUDA, Takeyoshi**
 **Osaka-shi**
 **Osaka 554-0024 (JP)**

- **HONAGA, Misako**
 **Osaka-shi**
 **Osaka 554-0024 (JP)**
- **NISHIGUCHI, Taro**
 **Itami-shi**
 **Hyogo 664-0016 (JP)**
- **SASAKI, Makoto**
 **Itami-shi**
 **Hyogo 664-0016 (JP)**
- **FUJIWARA, Shinsuke**
 **Itami-shi**
 **Hyogo 664-0016 (JP)**
- **NAMIKAWA, Yasuo**
 **Osaka-shi**
 **Osaka 554-0024 (JP)**

(74) Representative: **Grünecker, Kinkeldey,**
**Stockmair & Schwanhäusser**
**Anwaltssozietät**
**Leopoldstrasse 4**
**80802 München (DE)**

(54) **INSULATING GATE TYPE BIPOLAR TRANSISTOR**

(57)    An IGBT (100), which is a vertical type IGBT allowing for reduced on-resistance while restraining defects from being produced, includes: a silicon carbide substrate (1), a drift layer (3), a well region (4), an $n^+$ region (5), an emitter contact electrode (92), a gate oxide film (91), a gate electrode (93), and a collector electrode (96). The silicon carbide substrate (1) includes: a base layer (10) made of silicon carbide and having p type conductivity; and a SiC layer (20) made of single-crystal silicon carbide and disposed on the base layer (10). The base layer (10) has a p type impurity concentration exceeding $1 \times 10^{18}$ cm$^{-3}$.

FIG.1

EP 2 432 022 A1

## Description

TECHNICAL FIELD

The present invention relates to an insulated gate bipolar transistor (IGBT), more particularly, an IGBT allowing for reduced on-resistance while restraining defects such as micro pipes, stacking faults, and dislocations.

BACKGROUND ART

In recent years, in order to achieve high breakdown voltage, low loss, and utilization of semiconductor devices under a high temperature environment, silicon carbide (SiC) has begun to be adopted as a material for a semiconductor device. Silicon carbide is a wide band gap semiconductor having a band gap larger than that of silicon, which has been conventionally widely used as a material for semiconductor devices. Hence, by adopting silicon carbide as a material for a semiconductor device, the semiconductor device can have a high breakdown voltage, reduced on-resistance, and the like. Further, the semiconductor device thus adopting silicon carbide as its material has characteristics less deteriorated even under a high temperature environment than those of a semiconductor device adopting silicon as its material, advantageously.

In order to manufacture a high-performance IGBT adopting silicon carbide as its material, it is effective to employ a process of preparing a substrate made of silicon carbide (silicon carbide substrate), and forming an epitaxial growth layer made of SiC on the silicon carbide substrate. Further, when manufacturing a vertical type IGBT using such a silicon carbide substrate, the on-resistance of the IGBT can be reduced by reducing the resistivity of the substrate in the thickness direction thereof as much as possible. In order to reduce the resistivity of the substrate in the thickness direction thereof, for example, there can be employed a method of introducing an impurity into the substrate at a high concentration (for example, see R. C. GLASS et al., "SiC Seeded Crystal Growth", Phys. stat. sol. (b), 1997, 202, p149-162 (Non-Patent Literature 1)). Further, in order to effectively modulate conductivity in a drift layer by means of minority carrier injection, it is required to form a high-quality epitaxial growth layer having fewer dislocations and defects.

CITATION LIST

NON PATENT LITERATURE

NPL 1: R. C. GLASS et al., "SiC Seeded Crystal Growth", Phys. stat. sol.(b), 1997, 202, p149-162

SUMMARY OF INVENTION

TECHNICAL PROBLEM

However, when the resistivity of the substrate is reduced by introducing a p type impurity into the substrate at a high concentration in order to obtain a p type silicon carbide substrate (silicon carbide substrate having p type conductivity) suitable for fabrication of a vertical type IGBT, densities of defects such as micro pipes, stacking faults, and dislocations become high therein. When an epitaxial growth layer made of SiC is formed on the silicon carbide substrate, the defects are propagated to the epitaxial growth layer. The defects in the epitaxial growth layer serve as minor carrier traps to decrease carrier lifetime. Further, when fabricating a vertical type IGBT using the silicon carbide substrate, the conductivity modulation is prevented due to the high defect densities, which results in decreased forward characteristics of the IGBT, disadvantageously.

In view of these, the present invention has its object to provide a vertical type IGBT allowing for reduced on-resistance while restraining defects from being produced.

SOLUTION TO PROBLEM

An insulated gate bipolar transistor (IGBT) according to the present invention includes: a silicon carbide substrate; a drift layer made of single-crystal silicon carbide, disposed on/over one main surface of the silicon carbide substrate, and having n type conductivity; a well region having p type conductivity and disposed to include a first main surface of the drift layer opposite to the silicon carbide substrate; an emitter region having n type conductivity and disposed to include the first main surface within the well region; an emitter electrode disposed on the first main surface in contact with the emitter region; an insulating film formed of an insulator and disposed on the first main surface in contact with the well region; a gate electrode disposed on the insulating film; and a collector electrode disposed on the other main surface of the silicon carbide substrate. The silicon carbide substrate includes: a base layer made of silicon carbide and having p type conductivity; and a SiC layer made of single-crystal silicon carbide and disposed on the base layer. The base layer has a p type impurity concentration exceeding $1 \times 10^{18}$ cm$^{-3}$.

The present inventors have fully studied approaches for reducing resistivity of a silicon carbide substrate in the thickness direction thereof while restraining defects such as micro pipes, stacking faults, and dislocations from being produced. As a result, the following finding was obtained. Specifically, stacking faults can be restrained from being produced at least in the SiC layer in the following manner. That is, the base layer of the silicon carbide substrate is adapted to have a p type impurity concentration (p type impurity density) exceeding $1 \times 10^{18}$ cm$^{-3}$ to decrease the resistivity thereof, the SiC layer is adapted to contain an impurity to such an extent that defects such as micro pipes, stacking faults, and dislocations are prevented from being produced, and the SiC layer is provided on the base layer. Further, by forming the epitaxial growth layer (layer constituting an active layer) made of SiC on such a SiC layer so as to fabricate the IGBT, the resistivity of the silicon carbide substrate can be reduced by the existence of the base layer, while preventing influence of defects, such as micro pipes, stacking faults, and dislocations, which can be produced in the base layer, over the characteristics of the IGBT.

As such, according to the IGBT of the present invention, there can be provided a vertical type IGBT allowing for reduced on-resistance while restraining production of defects. Here, the term "impurity" refers to an impurity to be introduced to produce a majority carrier in the silicon carbide substrate. Further, the p type impurity concentration of the base layer can be equal to or smaller than $1 \times 10^{21}$ cm$^{-3}$. Meanwhile, the p type impurity concentration of the base layer may be equal to or greater than $1 \times 10^{20}$ cm$^{-3}$. An exemplary, usable impurity introduced into the base layer is Al (aluminum), B (boron), or the like.

Further, the base layer and the SiC layer are connected to each other, for example. Accordingly, the silicon carbide substrate can be readily obtained in which the SiC layer is disposed while preventing defects in the base layer from being propagated thereto. On this occasion, the base layer and the SiC layer may be directly connected to each other, or may be connected to each other via an intermediate layer.

In the IGBT, the impurity contained in the base layer may be different from that contained in the SiC layer. In this way, an IGBT can be obtained which includes the silicon carbide substrate containing impurities appropriately depending on intended purpose of use.

In the IGBT, the base layer may contain Al (aluminum) as an impurity introduced therein. Al is suitable as a p type impurity for supplying the SiC with positive holes, which serve as majority carriers.

In the IGBT, the base layer may be made of single-crystal silicon carbide and a half width of X-ray rocking curve of the SiC layer may be smaller than that of the base layer.

SiC does not have a liquid phase at an atmospheric pressure. Generally, in a sublimation recrystallizing method, which is performed as a method for growing a bulk single-crystal SiC, the crystal growth temperature is very high, specifically, equal to or greater than 2000°C, which makes it difficult to control and stabilize the growth conditions. Hence, it is difficult for a substrate made of single-crystal SiC to keep its high quality and have a large diameter. Meanwhile, for efficient manufacturing in a process of manufacturing an IGBT using a silicon carbide substrate, a substrate provided with predetermined uniform shape and size is required. Hence, even when a high-quality silicon carbide single-crystal (for example, silicon carbide single-crystal having a high crystallinity) is obtained, a region that cannot be processed into such a predetermined shape and the like by cutting, etc., may not be effectively used.

To address this, in the silicon carbide substrate constituting the IGBT of the present invention, on the base layer processed into the predetermined shape and size, there can be disposed the SiC layer having a smaller half width of the X-ray rocking curve, i.e., having higher crystallinity than that of the base layer but not formed into the desired shape and the like. Such a silicon carbide substrate has the predetermined uniform shape and size, thus attaining efficient manufacturing of IGBTs. Further, such a silicon carbide substrate utilizes the high-quality SiC layer to manufacture an IGBT, thereby effectively utilizing the high-quality single-crystal silicon carbide. As a result, the manufacturing cost of the IGBT can be reduced.

In the IGBT, the SiC layer may have p type conductivity, and may have an impurity concentration of not more than $1 \times 10^{18}$ cm$^{-3}$. This can restrain production of defects in the SiC layer, such as micro pipes, stacking faults, and dislocations, more securely.

In the IGBT, the insulating film may be made of silicon dioxide. Accordingly, the above-described insulating film can be formed readily.

In the silicon carbide substrate of the IGBT, the SiC layer has a main surface opposite to the base layer and having an off angle of not less than 50° and not more than 65° relative to a {0001} plane.

By growing single-crystal silicon carbide of hexagonal system in the <0001> direction, a high-quality single-crystal can be fabricated efficiently. From such a silicon carbide single-crystal grown in the <0001> direction, a silicon carbide substrate having a main surface corresponding to the {0001} plane can be obtained efficiently. Meanwhile, by using a silicon carbide substrate having a main surface having an off angle of not less than 50° and not more than 65° relative to the plane orientation of {0001}, an IGBT with high performance may be manufactured.

Specifically, a silicon carbide substrate used for fabrication of an IGBT generally has a main surface having an off angle of approximately 8° relative to a plane orientation of {0001}. An epitaxial growth layer (active layer) is formed on this main surface and an insulating film (oxide film), an electrode, and the like are formed on this active layer, thereby obtaining an IGBT. In this IGBT, a channel region is formed in a region including an interface between the active layer and the insulating film. However, in the IGBT having such a structure, a multiplicity of interface states are formed around the interface between the active layer and the insulating film, i.e., the location in which the channel region is formed, due to the substrate's main surface having an off angle of approximately 8° or smaller relative to the plane orientation of {0001} . This hinders traveling of carriers, thus decreasing channel mobility.

To address this, in the silicon carbide substrate, the main surface of the SiC layer opposite to the base layer is adapted to have an off angle of not less than 50° and not more than 65° relative to the {0001} plane, thereby reducing formation of the interface states. In this way, an IGBT can be fabricated which allows for reduced on-resistance.

In the silicon carbide substrate of the IGBT, the main surface of the SiC layer opposite to the base layer may have an off orientation forming an angle of not more than 5° relative to a <1-100> direction.

The <1-100> direction is a representative off orientation in a silicon carbide substrate. Variation in the off orientation resulting from variation in a slicing process of the process of manufacturing the substrate is adapted to be 5° or smaller, which allows an epitaxial growth layer (active layer) to be formed readily on the silicon carbide substrate.

In the silicon carbide substrate, the main surface of the SiC layer opposite to the base layer may have an off angle of not less than -3° and not more than 5° relative to a {03-38} plane in the <1-100> direction. Accordingly, channel mobility can be further improved in the case where an IGBT is fabricated using the silicon carbide substrate. Here, setting the off angle at not less than -3° and not more than +5° relative to the plane orientation of {03-38} is based on a fact that particularly high channel mobility was obtained in this set range as a result of inspecting a relation between the channel mobility and the off angle.

Further, the "off angle relative to the {03-38} plane in the <1-100> direction" refers to an angle formed by an orthogonal projection of a normal line of the above-described main surface to a flat plane defined by the <1-100> direction and the <0001> direction, and a normal line of the {03-38} plane. The sign of positive value corresponds to a case where the orthogonal projection approaches in parallel with the <1-100> direction whereas the sign of negative value corresponds to a case where the orthogonal projection approaches in parallel with the <0001> direction.

It should be noted that the plane orientation of the main surface is more preferably substantially {03-38}. Here, the expression "the main surface has a plane orientation of substantially {03-38}" is intended to encompass a case where the plane orientation of the main surface of the substrate is included in a range of off angle such that the plane orientation can be substantially regarded as {03-38} in consideration of processing accuracy of the substrate. In this case, the range of off angle is, for example, a range of off angle of $\pm 2°$ relative to {03-38}. Accordingly, the above-described channel mobility can be further improved.

In the silicon carbide substrate of the IGBT, the main surface of the SiC layer opposite to the base layer may have an off orientation forming an angle of not more than 5° relative to a <11-20> direction.

<11-20> is a representative off orientation in a silicon carbide substrate, as with the <1-100> direction. Variation in the off orientation resulting from variation in the slicing process of the process of manufacturing the substrate is adapted to be $\pm 5°$, which allows an epitaxial growth layer (active layer) to be formed readily on the SiC substrate.

In the IGBT, the base layer may be made of single-crystal silicon carbide. In this case, the SiC layer preferably has a defect density lower than that of the base layer.

For example, in the IGBT, the SiC layer preferably has a micro pipe density smaller than that of the base layer.

Further, preferably in the IGBT, the SiC layer has a dislocation density lower than that of the base layer.

Further, preferably in the IGBT, the SiC layer has a threading screw dislocation density smaller than that of the base layer. Further, preferably in the IGBT, the SiC layer preferably has a threading edge dislocation density smaller than that of the base layer. Further, preferably in the IGBT, the SiC layer has a basal plane dislocation density smaller than that of the base layer. Further, preferably in the IGBT, the SiC layer has a composite dislocation density smaller than that of the base layer. Further, preferably in the IGBT, the SiC layer has a stacking fault density smaller than that of the base layer. Further, preferably in the IGBT, the SiC layer has a point defect density smaller than that of the base layer.

As compared with the base layer, the SiC layer is adapted to have the reduced defect densities such as the micro pipe density, the threading screw dislocation density, the threading edge dislocation density, the basal plane dislocation density, the composite dislocation density, the stacking fault density, and the point defect density. Such a SiC layer allows a high-quality active layer to be formed on the SiC layer. The active layer can be formed by, for example, combining epitaxial growth and ion implantation of an impurity.

In the IGBT, a plurality of the SiC layers may be stacked. In this way, there can be obtained an IGBT including the silicon carbide substrate including the plurality of SiC layers corresponding to intended functions.

In the IGBT, the silicon carbide substrate may further include an intermediate layer disposed between the base layer and the SiC layer and made of a conductor or a semiconductor, and the intermediate layer connects the base layer and the SiC layer to each other.

Thus, by employing the structure in which the base layer and the SiC layer are connected to each other by the intermediate layer, there can be readily obtained the silicon carbide substrate in which the SiC layer is provided on the base layer having a p type impurity concentration exceeding $1 \times 10^{18}$ cm$^{-3}$, while preventing propagation of the defects of the base layer thereto. Further, when the intermediate layer is made of a conductor or a semiconductor, they can be connected to each other without inhibiting conductivity in the thickness direction thereof.

In the IGBT, the intermediate layer may be made of a metal. The metal constituting this intermediate layer may have a silicided portion. Further, in the IGBT, the intermediate layer may be made of carbon. Further, the intermediate layer may be made of amorphous silicon carbide. In this way, conductivity can be readily secured in the thickness direction of the substrate.

In the silicon carbide substrate constituting the IGBT, the base layer may include a single-crystal layer including its main surface facing the SiC layer and made of single-crystal silicon carbide. Accordingly, a difference in physical property (for example, difference in linear expansion coefficient) becomes small between the base layer and the SiC layer, thereby restraining warpage of the silicon carbide substrate. A region of the base layer other than the single-crystal layer may be formed of a non single-crystal layer such as polycrystal silicon carbide, amorphous silicon carbide, or silicon carbide sintered compact. Accordingly, the manufacturing cost of the semiconductor device can be reduced.

Further, in the silicon carbide substrate, a half width of X-ray rocking curve of the SiC layer is preferably smaller than that of the single-crystal layer. Furthermore, in the silicon carbide substrate, the SiC layer preferably has a micro pipe density smaller than that of the single-crystal layer. Further, in the silicon carbide substrate, the SiC layer preferably has a dislocation density lower than that of the single-crystal layer. In this way, a high-quality active layer can be formed on the SiC layer. The active layer can be formed by, for example, combining epitaxial growth and ion implantation of an impurity.

ADVANTAGEOUS EFFECTS OF INVENTION

As apparent from the description above, according to the IGBT of the present invention, there can be provided a vertical type IGBT allowing for reduced on-resistance while restraining defects from being produced.

BRIEF DESCRIPTION OF DRAWINGS

Fig. 1 is a schematic cross sectional view showing a structure of an IGBT.
Fig. 2 is a schematic cross sectional view showing a structure of a silicon carbide substrate.
Fig. 3 is a flowchart schematically showing a method for manufacturing the IGBT.
Fig. 4 is a schematic cross sectional view for illustrating the method for manufacturing the IGBT.
Fig. 5 is a schematic cross sectional view for illustrating the method for manufacturing the IGBT.
Fig. 6 is a schematic cross sectional view for illustrating the method for manufacturing the IGBT.
Fig. 7 is a flowchart schematically showing a method for manufacturing the silicon carbide substrate.
Fig. 8 is a schematic cross sectional view showing a structure of an IGBT in a second embodiment.
Fig. 9 is a flowchart schematically showing a method for manufacturing a silicon carbide substrate in a third embodiment.
Fig. 10 is a schematic cross sectional view for illustrating the method for manufacturing the silicon carbide substrate in the third embodiment.
Fig. 11 is a schematic cross sectional view for illustrating the method for manufacturing the silicon carbide substrate in the third embodiment.
Fig. 12 is a schematic cross sectional view for illustrating the method for manufacturing the silicon carbide substrate in the third embodiment.
Fig. 13 is a schematic cross sectional view showing a structure of a silicon carbide substrate in a fourth embodiment.
Fig. 14 is a schematic cross sectional view showing a structure of a silicon carbide substrate in a fifth embodiment.
Fig. 15 is a flowchart schematically showing a method for manufacturing the silicon carbide substrate in the fifth embodiment.
Fig. 16 is a schematic cross sectional view showing a structure of a silicon carbide substrate in a sixth embodiment.
Fig. 17 is a flowchart schematically showing a method for manufacturing the silicon carbide substrate in the sixth embodiment.
Fig. 18 is a schematic cross sectional view showing a structure of a silicon carbide substrate in a seventh embodiment.
Fig. 19 is a flowchart schematically showing a method for manufacturing the silicon carbide substrate in the seventh embodiment.
Fig. 20 is a schematic cross sectional view for illustrating the method for manufacturing the silicon carbide substrate in the seventh embodiment.

Fig. 21 shows a relation between impurity concentration and mobility in p type 4H-SiC.

DESCRIPTION OF EMBODIMENTS

The following describes embodiments of the present invention with reference to figures. It should be noted that in the below-mentioned figures, the same or corresponding portions are given the same reference characters and are not described repeatedly.

(First Embodiment)

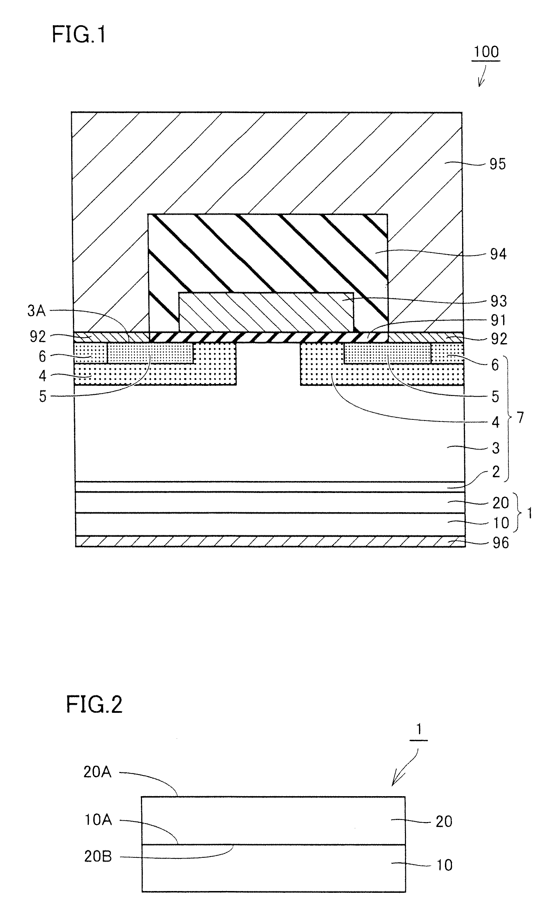

First, one embodiment of the present invention, i.e., a first embodiment will be described. Referring to Fig. 1, an IGBT100, which is an insulated gate bipolar transistor in the present embodiment, includes: a silicon carbide substrate 1 having p type conductivity; a buffer layer 2 (which may have n type conductivity or p type conductivity); a drift layer 3 made of silicon carbide and having n type conductivity; a pair of well regions 4 each having p type conductivity; n+ regions 5 each having n type conductivity and serving as an emitter region; and p+ regions 6 each having p type conductivity and serving as a high-concentration p type region.

Buffer layer 2 is formed on one main surface of silicon carbide substrate 1, and contains an impurity at a concentration higher than that in drift layer 3. Drift layer 3 is formed on buffer layer 2, and contains an n type impurity and therefore has n type conductivity.

The pair of well regions 4 are formed in drift layer 3 to be separated from each other and include a main surface 3A of drift layer 3 opposite to its main surface at the silicon carbide substrate 1 side. Each of well regions 4 contains a p type impurity and therefore has p type conductivity. The p type impurity contained in well region 4 is, for example, aluminum (Al), boron (B), or the like.

N+ regions 5, which include main surface 3A described above, are surrounded by well regions 4 and are formed within the pair of well regions 4. Each of n+ regions 5 contains an n type impurity such as P at a concentration (density) higher than that of the n type impurity contained in drift layer 3. P+ regions 6, which include main surface 3A, are surrounded by well regions 4 and are formed adjacent to n+ regions 5 within the pair of well regions 4 respectively. Each of p+ regions 6 contains a p type impurity such as Al at a concentration (density) higher than that of the p type impurity contained in each of well regions 4. Buffer layer 2, drift layer 3, well regions 4, n+ regions 5, and p+ regions 6 constitute an active layer 7.

Referring to Fig. 1, IGBT 100 further includes: a gate oxide film 91 serving as a gate insulating film; a gate electrode 93; a pair of emitter contact electrodes 92; an interlayer insulating film 94; an emitter wire 95; and a collector electrode 96.

Gate oxide film 91 is formed on and in contact with main surface 3A of drift layer 3 so as to extend from a location on the upper surface of one n+ region 5 to a location on the upper surface of the other n+ region 5. Gate oxide film 91 is made of, for example, silicon dioxide ($SiO_2$).

Gate electrode 93 is disposed on and in contact with gate oxide film 91 so as to extend from a location over one n+ region 5 to a location over the other n+ region 5. Further, gate electrode 93 is made of a conductor such as polysilicon having an impurity added therein or Al.

Emitter contact electrodes 92 are disposed in contact with main surface 3A, extend from respective locations on the pair of n+ regions 5, and reach locations on p+ regions 6. Each of emitter contact electrodes 92 is made of a material capable of ohmic contact with both n+ regions 5 and p+ regions 6, such as NiSi (nickel silicide).

Interlayer insulating film 94 is formed to surround gate electrode 93 over main surface 3A of drift layer 3, and extends from a location over one well region 4 to a location over the other well region 4. Interlayer insulating film 94 is made of, for example, silicon dioxide ($SiO_2$), which is an insulator.

Emitter wire 95 surrounds interlayer insulating film 94 over main surface 3A of drift layer 3, and extends onto the upper surfaces of emitter contact electrodes 92. Emitter wire 95 is made of a conductor such as Al, and is electrically connected to n+ regions 5 via emitter contact electrodes 92.

Collector electrode 96 is formed in contact with the main surface of silicon carbide substrate 1 opposite to the side at which drift layer 3 is formed. Collector electrode 96 is made of a material capable of ohmic contact with silicon carbide substrate 1, such as NiSi. Collector electrode 96 is electrically connected to silicon carbide substrate 1.

Referring to Fig. 2, in the present embodiment, silicon carbide substrate 1 constituting IGBT 100 includes: a base layer 10 made of single-crystal silicon carbide and having p type conductivity: and a SiC layer 20 made of single-crystal silicon carbide, arranged on base layer 10, and having p type conductivity. Base layer 10 has a p type impurity concentration exceeding $1 \times 10^{18}$ cm$^{-3}$. Hence, IGBT 100 in the present embodiment is a vertical type IGBT allowing for reduced on-resistance while restraining defects from being produced. It should be noted that there is a boundary between base layer 10 and SiC layer 20 and defect density may be discontinuous at this boundary. Further, base layer 10 employed may be made of, for example, single-crystal silicon carbide, polycrystal silicon carbide, amorphous silicon carbide, a silicon carbide sintered compact, or a combination thereof.

The following describes operations of IGBT 100. Referring to Fig. 1, when gate electrode 93 is fed with a positive voltage and the positive voltage exceeds a threshold value, an inversion layer is formed at portions of well regions 4 in contact with gate oxide film 91 below gate electrode 93, thereby electrically connecting n$^+$ regions 5 and drift layer 3 to each other. Accordingly, electrons are injected from n$^+$ regions 5 into drift layer 3. Correspondingly, positive holes are supplied from silicon carbide substrate 1 via buffer layer 2 to drift layer 3. As a result, IGBT 100 is brought into ON state, thereby bringing about conductivity modulation in drift layer 3 to decrease resistance between emitter contact electrode 92 and collector electrode 96. In such a state, current flows. On the other hand, when the positive voltage applied to gate electrode 93 is equal to or smaller than the threshold value, the inversion layer is not formed. Accordingly, a reverse bias state is maintained between drift layer 3 and well region 4. As a result, IGBT 100 is brought into OFF state, with the result that no current flows.

In IGBT 100, base layer 10 may be made of single-crystal silicon carbide. Further, SiC layer 20 preferably has a micro pipe density smaller than that of base layer 10. Further, in IGBT 100, SiC layer 20 preferably has a threading screw dislocation density smaller than that of base layer 10. Further, in IGBT 100, SiC layer 20 preferably has a threading edge dislocation density smaller than that of base layer 10. Further, in IGBT 100, SiC layer 20 preferably has a basal plane dislocation density smaller than that of base layer 10. Further, in IGBT 100, SiC layer 20 preferably has a composite dislocation density smaller than that of base layer 10. Further, in IGBT 100, SiC layer 20 preferably has a stacking fault density smaller than that of base layer 10. Further, in IGBT 100, SiC layer 20 preferably has a point defect density smaller than that of base layer 10.

Thus, as compared with base layer 10, SiC layer 20 has the reduced defect densities such as the micro pipe density, the threading screw dislocation density, the threading edge dislocation density, the basal plane dislocation density, the composite dislocation density, the stacking fault density, and the point defect density. Such a SiC layer 20 allows a high-quality active layer 7 to be formed on SiC layer 20.

Further, in IGBT 100, SiC layer 20 may have a p type impurity concentration of $1 \times 10^{18}$ cm$^{-3}$ or smaller. Accordingly, defects such as micro pipes, stacking faults, and dislocations can be restrained more securely from being produced in SiC layer 20.

Further, in IGBT 100, base layer 10 is made of single-crystal silicon carbide, and the half width of X-ray rocking curve of SiC layer 20 may be smaller than that of base layer 10.

Accordingly, a single-crystal silicon carbide having predetermined uniform shape and size and having relatively low crystallinity is employed as base layer 10 of silicon carbide substrate 1, while a single-crystal silicon carbide having a high crystallinity and not having the desired shape or the like is effectively utilized as SiC layer 20. As a result, the manufacturing cost of IGBT 100 can be reduced.

Further, in silicon carbide substrate 1 of IGBT 100, main surface 20A of SiC layer 20 opposite to base layer 10 preferably has an off angle of not less than 50° and no more than 65° relative to the {0001} plane. This restrains formation of interface state in the vicinity of an interface of active layer 7 with gate oxide film 91 in the case where active layer 7 is formed by means of epitaxial growth and ion implantation of impurity, thereby achieving reduced on-resistance of IGBT 100. The vicinity of the interface serves as a channel region.

Further, in silicon carbide substrate 1 of IGBT 100, main surface 20A of SiC layer 20 opposite to base layer 10 has an off orientation forming an angle of 5° or smaller relative to the <1-100> direction.

The <1-100> direction is a representative off orientation in a silicon carbide substrate. Variation in the off orientation resulting from variation in a slicing process of the process of manufacturing the substrate is adapted to be 5° or smaller, which allows an epitaxial growth layer (active layer 7) to be formed readily on silicon carbide substrate 1.

Further, in silicon carbide substrate 1 of IGBT 100, main surface 20A of SiC layer 20 opposite to base layer 10 has an off angle of not less than -3° and not more than 5° relative to the {03-38} plane in the <1-100> direction. Accordingly, channel mobility can be further improved in the case where IGBT 100 is fabricated using silicon carbide substrate 1.

Further, in silicon carbide substrate 1 of IGBT 100, main surface 20A of SiC layer 20 opposite to base layer 10 may have an off orientation forming an angle of 5° or smaller relative to the <11-20> direction.

<11-20> is a representative off orientation in a silicon carbide substrate, as with the <1-100> direction. Variation in the off orientation resulting from variation in the slicing process of the process of manufacturing the substrate is adapted to be ±5°, which allows an epitaxial growth layer (active layer 7) to be formed readily on SiC layer 20.

Here, in silicon carbide substrate 1 constituting IGBT 100, the impurity contained in base layer 10 may be different from that contained in SiC layer 20. In this way, IGBT 100 can be obtained which includes silicon carbide substrate 1 containing impurities appropriately depending on intended purpose of use.

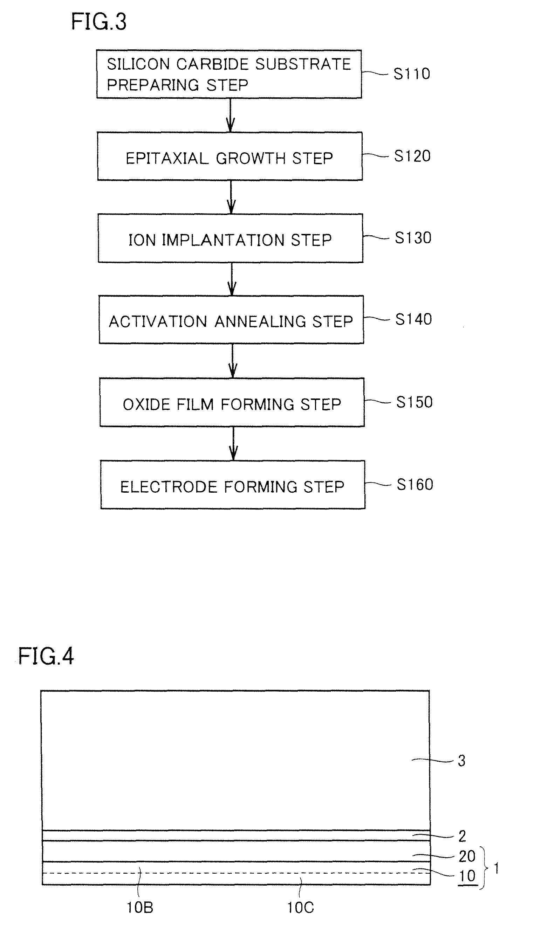

The following describes one exemplary method for manufacturing IGBT 100 in the first embodiment, with reference to Fig. 3-Fig. 6. Referring to Fig. 3, in the method for manufacturing IGBT 100 in the present embodiment, a silicon carbide substrate preparing step is first performed as a step (S110). In this step (S110), referring to Fig. 4, silicon carbide substrate 1 is prepared which include: base layer 10 made of single-crystal silicon carbide and having p type conductivity; and SiC layer 20 made of single-crystal silicon carbide, arranged on base layer 10, and having p type conductivity. Base layer 10 has a p type impurity concentration exceeding $1 \times 10^{18}$ cm$^{-3}$. In silicon carbide substrate 1 prepared in this step (S110), the following base layer 10 may be employed instead of base layer 10 entirely formed of single-crystal silicon carbide. That is, base layer 10 employed includes: a single-crystal layer 10B made of single-crystal silicon carbide and including main surface 10A facing SiC layer 20, and the other region 10C made of polycrystal silicon carbide, amorphous silicon carbide, or a silicon carbide sintered compact. Further, instead of base layer 10 entirely made of single-crystal silicon carbide, there may be employed a base layer 10 entirely made of polycrystal silicon carbide, amorphous silicon carbide, or silicon carbide sintered compact. A method for manufacturing silicon carbide substrate 1 will be described below.

Next, as a step (S120), an epitaxial growth step is performed. In this step (S120), referring to Fig. 4, buffer layer 2 and drift layer 3 each made of silicon carbide and having n type conductivity are formed sequentially on/over one main surface of silicon carbide substrate 1 by means of epitaxial growth.

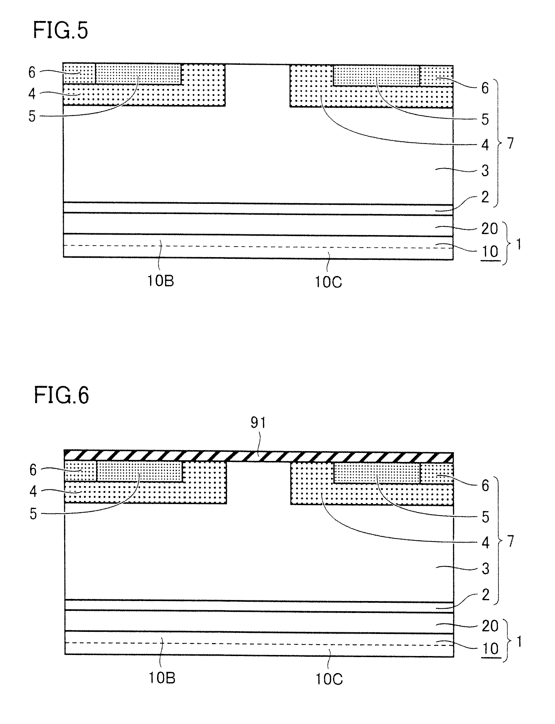

Next, as a step (S130), an ion implantation step is performed. In this step (S130), referring to Fig. 4 and Fig. 5, ion implantation is performed to form well regions 4, first. Specifically, for example, Al (aluminum) ions are introduced into drift layer 3, thereby forming well regions 4. Next, ion implantation is performed to form n$^+$ regions 5. Specifically, for example, P (phosphorus) ions are implanted into well regions 4, thereby forming n$^+$ regions 5 within well regions 4. Further, ion implantation is performed to form p$^+$ regions 6. Specifically, for example, Al ions are implanted into well regions 4, thereby forming p$^+$ regions 6 in well regions 4. The ions can be implanted using a mask layer formed on the main surface of drift layer 3, made of silicon dioxide (SiO$_2$), and having openings at desired regions for the ion implantations, for example.

Next, as a step (S140), an activation annealing step is performed. In this step (S140), for example, heat treatment is performed by heating to 1700°C in an inert gas atmosphere such as argon for 30 minutes. Accordingly, the impurities implanted in the above-described step (S130) are activated.

Next, as a step (S150), an oxide film forming step is performed. In this step (S150), referring to Fig. 5 and Fig. 6, for example, heat treatment is performed by heating to 1300°C in an oxygen atmosphere for 60 minutes, thereby forming oxide film 91 (gate oxide film).

Next, as a step (S160), an electrode forming step is performed. Referring to Fig. 1, in this step (S160), for example, a CVD method is used to form gate electrode 93 made of polysilicon having an impurity added therein to be a conductor, and then, interlayer insulating film 94 made of SiO$_2$, which is an insulator, is formed on main surface 3 A using, for example, the CVD method so as to surround gate electrode 93. Next, for example, a nickel (Ni) film is formed by means of an evaporation method and is heated to be silicided, thereby forming emitter contact electrodes 92 and collector electrode 96. Next, for example, using the evaporation method, emitter wire 95 made of Al that is a conductor is formed to surround interlayer insulating film 94 over main surface 3A and extend to the locations over and on the upper surfaces of n$^+$ regions 5 and emitter contact electrodes 92. With the above-described procedure, IGBT 100 in the present embodiment is completed.

In the case where there is adopted in step (S110) a base layer 10 that includes single-crystal layer 10B made of single-crystal silicon carbide and including main surface 10A facing SiC layer 20 and includes the other region 10C made of polycrystal silicon carbide, amorphous silicon carbide, or silicon carbide sintered compact, a step of removing the other region 10C may be performed. In this way, IGBT 100 can be obtained which include base layer 10 made of single-crystal silicon carbide (see Fig. 1). Meanwhile, the step of removing region10C described above may not be performed. In this case, a non single-crystal layer (corresponding to region 10C described above) made of polycrystal silicon carbide, amorphous silicon carbide, or silicon carbide sintered compact is formed on the main surface of base layer 10 opposite to SiC layer 20 in IGBT 1 shown in Fig. 1 (i.e., as a lower layer in base layer 10 in Fig. 1). This non single-crystal layer does not have a great influence over characteristics of IGBT 100 as long as the resistivity thereof is low. Hence, when such a manufacturing process is employed, manufacturing cost of IGBT 100 can be reduced without any great influence over the characteristics thereof.

On this occasion, a half width of X-ray rocking curve of SiC layer 20 may be preferably smaller than that of single-crystal layer 10B. As such, SiC layer 20 having such a smaller half width of the X-ray rocking curve, i.e., having higher crystallinity than that of single-crystal layer 10B of base layer 10 is provided, thereby allowing a high-quality active layer 7 to be formed thereon.

Furthermore, SiC layer 20 may preferably has a micro pipe density smaller than that of single-crystal layer 10B. Further, SiC layer 20 may have a dislocation density lower than that of single crystal layer 10B. Further, SiC layer 20 may have a threading screw dislocation density smaller than that of single crystal layer 10B. Further, SiC layer 20 may have a threading edge dislocation density smaller than that of single crystal layer 10B. Further, SiC layer 20 may have a basal plane dislocation density smaller than that of single crystal layer 10B. Further, SiC layer 20 may have a composite dislocation density smaller than that of single crystal layer 10B. Further, SiC layer 20 may have a stacking fault density smaller than that of single crystal layer 10B. Further, SiC layer 20 may have a point defect density smaller than that of single crystal layer 10B.

Thus, as compared with single-crystal layer 10B of base layer 10, SiC layer 20 has the reduced defect densities such as the micro pipe density, the threading screw dislocation density, the threading edge dislocation density, the basal plane dislocation density, the composite dislocation density, the stacking fault density, and the point defect density. This allows IGBT 100 including a high-quality active layer 7 to be obtained.

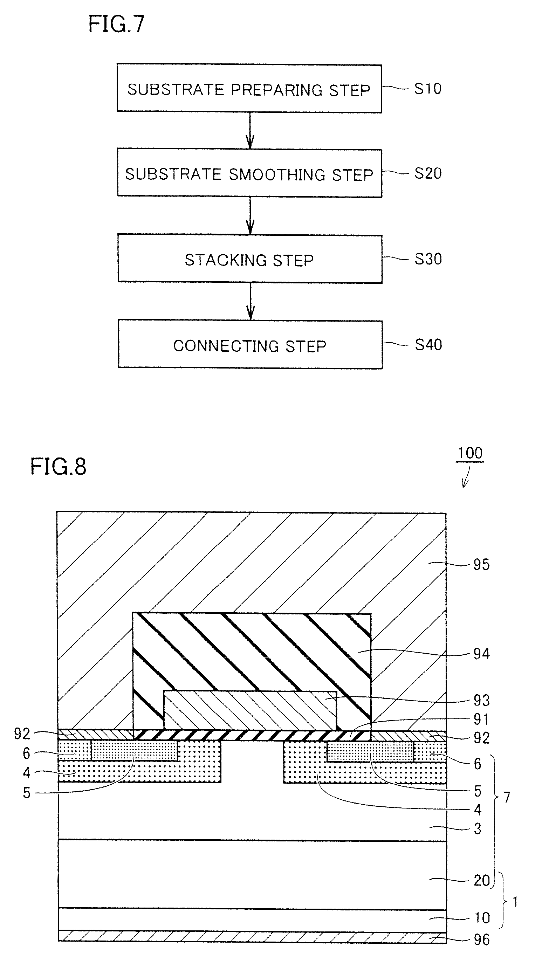

The following describes the silicon carbide substrate preparing step performed as step (S110) described above. Referring to Fig. 7, in manufacturing the silicon carbide substrate in the present embodiment, first, as step (S10), a substrate preparing step is performed. In this step (S10), referring to Fig. 2, a base substrate 10 and a SiC substrate 20 each formed of single-crystal silicon carbide and having p type conductivity are prepared.

SiC substrate 20 has main surface 20A, which will be the main surface of silicon carbide substrate 1 that will be obtained by this manufacturing method. Hence, on this occasion, the plane orientation of main surface 20A of SiC substrate 20 is selected in accordance with desired plane orientation of main surface 20A. Here, for example, a SiC substrate 20 having a main surface corresponding to the {03-38} plane is prepared. Meanwhile, a substrate having a p type impurity concentration greater than, for example, $1 \times 10^{18}$ cm$^{-3}$ is adopted as base substrate 10. Further, a substrate having a p type impurity concentration smaller than, for example, $1 \times 10^{18}$ cm$^{-3}$ is adopted as SiC substrate 20. Here, each of base substrate 10 and SiC substrate 20 including the p type impurities can be fabricated by slicing a source material crystal obtained by, for example, supplying a solid material or gaseous material of Al (TMA; Trimethyl Aluminum), which is an impurity, during crystal growth achieved by sublimation and recrystallization based on, for example, a Modified-Lely method.

Next, a substrate smoothing step is performed as a step (S20). Step (S20) is not an essential step, but can be performed when the smoothness of base substrate 10 and/or SiC substrate 20 prepared in step (S10) is insufficient. Specifically, for example, the main surface(s) of base substrate 10 and/or SiC substrate 20 are polished.

Meanwhile, step (S20) may be omitted, i.e., step (S30) may be performed without polishing the main surfaces of base substrate 10 and SiC substrate 20, which are to be brought into contact with each other. This reduces manufacturing cost of silicon carbide substrate 1. Further, for removal of damaged layers located in surfaces formed by slicing upon fabrication of base substrate 10 and SiC substrate 20, a step of removing the damaged layers may be performed by, for example, etching instead of step (S20) or after step (S20), and then step (S30) described below may be performed.

Next, a stacking step is performed as step (S30). In this step (S30), referring to Fig. 2, base substrate 10 and SiC substrate 20 are stacked on each other to bring their main surfaces 10A, 20B into contact with each other, thereby fabricating a stacked substrate.

Next, as step (S40), a connecting step is performed. In this step (S40), by heating the stacked substrate to fall within, for example, a range of temperature equal to or greater than the sublimation temperature of silicon carbide, base substrate 10 and SiC substrate 20 are connected to each other. In this way, referring to Fig. 2, silicon carbide substrate 1 including base layer 10 and SiC layer 20 is completed. Further, by heating to the temperature equal to or greater than the sublimation temperature, base substrate 10 and SiC substrate 20 can be connected to each other readily even in the case where step (S20) is not performed and step (S30) is performed without polishing the main surfaces of base substrate 10 and SiC substrate 20 which are to be brought into contact with each other. It should be noted that in this step (S40), the stacked substrate may be heated in an atmosphere obtained by reducing pressure of the atmospheric air. This reduces manufacturing cost of silicon carbide substrate 1.

Further, heating temperature for the stacked substrate in step (S40) is preferably not less than 1800°C and not more than 2500°C. If the heating temperature is lower than 1800°C, it takes a long time to connect base substrate 10 and SiC substrate 20, which results in decreased efficiency in manufacturing silicon carbide substrate 1. On the other hand, if the heating temperature exceeds 2500°C, surfaces of base substrate 10 and SiC substrate 20 become rough, which may result in generation of a multiplicity of crystal defects in silicon carbide substrate 1 to be fabricated. In order to improve efficiency in manufacturing while restraining generation of defects in silicon carbide substrate 1, the heating temperature for the stacked substrate in step (S40) is set at not less than 1 900°C and not more than 2100°C. Further, in this step (S40), the stacked substrate may be heated under a pressure higher than $10^{-1}$ Pa and lower than $10^4$ Pa. This can accomplish the above-described connection using a simple device, and provide an atmosphere for accomplishing the connection for a relatively short time, thereby achieving reduced manufacturing cost of silicon carbide substrate 1. Further, the atmosphere upon the heating in step (S40) may be inert gas atmosphere. In the case where the atmosphere is the inert gas atmosphere, the inert gas atmosphere preferably contains at least one selected from a group consisting of argon, helium, and nitrogen.

Further, in the method for manufacturing IGBT 100 in the present embodiment, IGBT 100 is manufactured using silicon carbide substrate 1 thus obtained.

(Second Embodiment)

The following describes another embodiment of the present invention, i.e., a second embodiment. Referring to Fig. 8, an IGBT 100 in the second embodiment has the basically the same structure and provides basically the same effect as those of IGBT 100 of the first embodiment described with reference to Fig. 1 and Fig. 2. However, silicon carbide substrate 1 in IGBT 100 of the second embodiment is different from that of the first embodiment in that SiC layer 20 contains an n type impurity and therefore has n type conductivity. Therefore, in the operation of IGBT 100 of the present embodiment, base layer 10 performs a function similar to that of silicon carbide substrate 1 of the first embodiment, and SiC layer 20 performs a function similar to a part of that of drift layer 3 of the first embodiment. In other words, SiC layer 20 serves as a part of active layer 7. Further, IGBT 100 can be manufactured in the same manner as in the first embodiment, except that SiC substrate 20 prepared in step (S10) has n type conductivity.

(Third Embodiment)

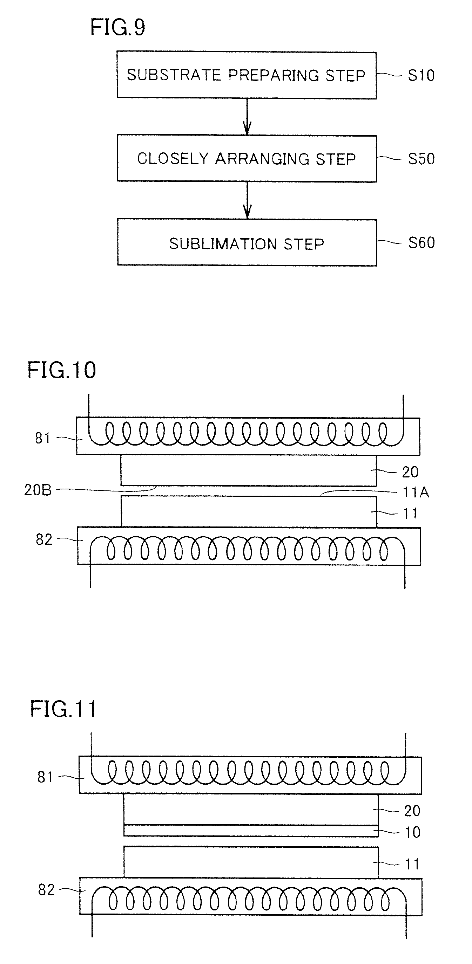

As a third embodiment, the following describes another method for manufacturing a silicon carbide substrate constituting an IGBT of the present invention, with reference to Fig. 9-Fig. 12. The method for manufacturing the silicon carbide substrate in the third embodiment is performed in basically the same manner as in the first embodiment. However, the method for manufacturing the silicon carbide substrate in the third embodiment is different from that of the first embodiment in terms of a process of forming base substrate 10.

Referring to Fig. 9, the substrate preparing step is first performed as step (S10) in the method for manufacturing the silicon carbide substrate in the third embodiment. In step (S10), referring to Fig. 10, SiC substrate 20 is prepared as with the first embodiment, and a material substrate 11 made of silicon carbide is prepared. Material substrate 11 may be made of single-crystal silicon carbide, polycrystal silicon carbide, or porous silicon carbide, or may be a sintered compact of silicon carbide. Further, instead of material substrate 11, material powder made of silicon carbide can be employed.

Here, the material substrate made of polycrystal silicon carbide can be fabricated in the following manner. First, in a low-pressure CVD (Chemical Vapor Deposition) method, hydrocarbon gas (methane, propane, acetylene, or the like) serving as a carbon source, and silane gas, silicon tetrachloride, or the like, each of which serves as a silicon source, are supplied to form polycrystal silicon carbide on a carbon base material heated to approximately 1300°C-1600°C. On this occasion, a source material (such as TMA) for Al, which is an impurity, is supplied. From the polycrystal silicon carbide thus obtained, the above-described material substrate is obtained.

Further, a base substrate formed of a sintered compact of silicon carbide can be fabricated by sintering material powder containing a predetermined amount of Al, which is an impurity.

Next, as step (S50), a closely arranging step is performed. In this step (S50), referring to Fig. 10, SiC substrate 20 and material substrate 11 are held respectively by a first heater 81 and a second heater 82 disposed face to face with each other. Here, an appropriate value of a space between SiC substrate 20 and material substrate 11 is considered to be associated with a mean free path for a sublimation gas obtained upon heating in a below-described step (S60). Specifically, the average value of the space between SiC substrate 20 and material substrate 11 can be set to be smaller than the mean free path for the sublimation gas obtained upon heating in the below-described step (S60). For example, strictly, a mean free path for atoms and molecules depends on atomic radius and molecule radius at a pressure of 1 Pa and a temperature of 2000°C, but is approximately several cm to several ten cm. Hence, realistically, the space is preferably set at several cm or smaller. More specifically, SiC substrate 20 and material substrate 11 are arranged close to each other such that their main surfaces 11A, 20B face each other with a space of not less than 1 $\mu$m and not more than 1 cm therebetween. When the average value of the space is set at 1 cm or smaller, the distribution in film thickness of base layer 10 formed in the below-described step (S60) can be reduced further. Furthermore, when the average value of the space is 1 mm or smaller, the distribution in film thickness of growth layer 30 can be reduced further. Meanwhile, with the average value of the space being 1 $\mu$m or greater, there can be secured a sufficient space for sublimation of silicon carbide. It should be noted that this sublimation gas is a gas formed by sublimation of solid silicon carbide, and includes Si, $Si_2C$, and $SiC_2$, for example.

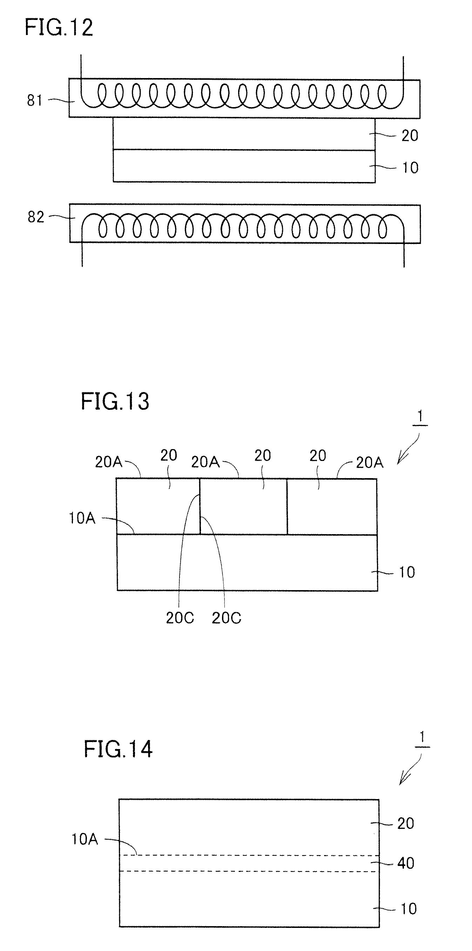

Next, as step (S60), a sublimation step is performed. In this step (S60), SiC substrate 20 is heated to a predetermined substrate temperature by first heater 81. Further, material substrate 11 is heated to a predetermined material temperature by second heater 82. On this occasion, material substrate 11 is heated to reach the material temperature, thereby sublimating SiC from the surface of material substrate 11. On the other hand, the substrate temperature is set lower than the material temperature. Specifically, for example, the substrate temperature is set lower than the material temperature by not less than 1 °C and not more than 100°C. The substrate temperature is preferably 1800°C or greater and 2500°C or smaller. Accordingly, as shown in Fig. 11, SiC sublimated from material substrate 11 in the form of gas reaches the surface of SiC substrate 20 and is accordingly solidified thereon, thereby forming base layer 10. With this state being maintained, as shown in Fig. 12, all the SiC constituting material substrate 11 is sublimated and is transferred onto the surface of SiC substrate 20. Accordingly, step (S60) is completed, thereby completing silicon carbide substrate 1 shown in Fig. 2.

(Fourth Embodiment)

The following describes yet another embodiment of the present invention, i.e., a fourth embodiment. An IGBT in the fourth embodiment has basically the same structure as that in the first embodiment. However, the IGBT in the fourth embodiment is different from that of the first embodiment in terms of manufacturing method.

Specifically, a silicon carbide substrate different in structure from that of the first embodiment is prepared in the silicon carbide substrate preparing step performed as step (S110) in the method for manufacturing the IGBT in the fourth embodiment. Referring to Fig. 13, in silicon carbide substrate 1 prepared in the fourth embodiment, a plurality of SiC layers 20 are arranged side by side when viewed in a planar view. In other words, the plurality of SiC layers 20 are arranged along main surface 10A of base layer 10. More specifically, the plurality of SiC layers 20 are arranged in the form of a matrix on base layer 10 such that adjacent SiC layers 20 are in contact with each other. Accordingly, silicon carbide substrate 1 of the present embodiment can be handled as a substrate having high-quality SiC layers 20 and a large diameter. Utilization of such a silicon carbide substrate 1 allows for efficient manufacturing process of IGBTs. Further, referring to Fig. 13, each of adjacent SiC layers 20 has an end surface 20C substantially perpendicular to main surface 20A of SiC layer 20. In this way, silicon carbide substrate 1 of the present embodiment can be readily manufactured. Here, for example, when end surface 20C and main surface 20A form an angle of not less than 85° and not more than 95°, it can be determined that end surface 20C and main surface 20A are substantially perpendicular to each other. It should be noted that silicon carbide substrate 1 in the fourth embodiment can be manufactured in a manner similar to that in the first embodiment or the third embodiment as follows. That is, in step (S30) of the first embodiment, a plurality of SiC substrates 20 each having an end surface 20C substantially perpendicular to main surface 20A thereof are arranged side by side when viewed in a planar view (see Fig. 2). Alternatively, in step (S50) of the third embodiment, a plurality of SiC substrates 20 each having an end surface 20C substantially perpendicular to main surface 20A thereof are arranged side by side on and held by first heater 81 (see Fig. 10).

Further, in the method for manufacturing IGBT 100 in the present embodiment, IGBT 100 is manufactured using silicon carbide substrate 1 thus obtained. Here, by forming active layer 7 and the like on SiC layers 20 of silicon carbide substrate 1 shown in Fig. 13, a plurality of IGBTs 100 arranged side by side when viewed in a planar view are fabricated. On this occasion, each IGBT 100 is fabricated so as not to extend across a boundary region between adjacent SiC layers 20.

(Fifth Embodiment)

The following describes yet another embodiment of the present invention, i.e., a fifth embodiment. An IGBT 100 in the fifth embodiment has basically the same structure and provides basically the same effects as those of IGBT 100 in the first embodiment. However, IGBT 100 in the fifth embodiment is different from that of the first embodiment in terms of structure of silicon carbide substrate 1.

Namely, referring to Fig. 14, in silicon carbide substrate 1 in the fifth embodiment, an amorphous SiC layer 40 is disposed between base layer 10 and SiC layer 20 as an intermediate layer made of amorphous SiC. Then, base layer 10 and SiC layer 20 are connected to each other by this amorphous SiC layer 40. Amorphous SiC layer 40 thus existing facilitates fabrication of the silicon carbide substrate in which SiC layer 20 is disposed while preventing defects in base layer 10 from being propagating thereto.

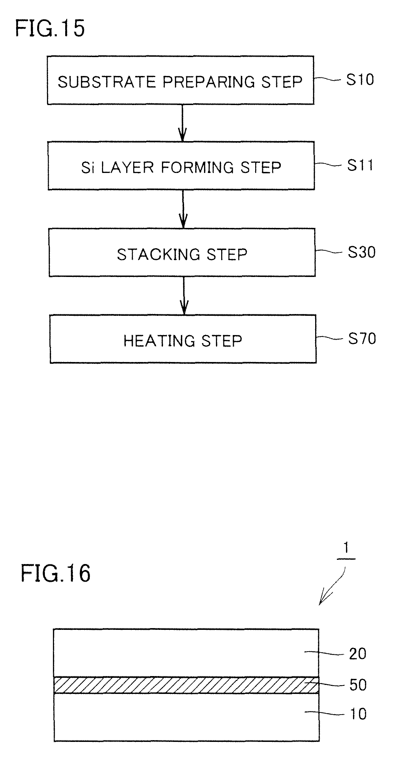

The following describes a method for manufacturing silicon carbide substrate 1 in the fifth embodiment. Referring to Fig. 15, in the method for manufacturing silicon carbide substrate 1 in the fifth embodiment, the substrate preparing step is performed as step (S10) in the same way as in the first embodiment, so as to prepare base substrate 10 and SiC substrate 20.

Next, a Si layer forming step is performed as a step (S11). In this step (S11), a Si layer having a thickness of approximately 100 nm is formed on one main surface of base substrate 10 prepared in step (S10), for example. This Si layer can be formed using a sputtering method, for example.

Next, a stacking step is performed as step (S30). In this step (S30), SiC substrate 20 prepared in step (S10) is placed on the Si layer formed in step (S11). In this way, a stacked substrate is obtained in which SiC substrate 20 is provided over base substrate 10 with the Si layer interposed therebetween.

Next, as a step (S70), a heating step is performed. In this step (S70), the stacked substrate fabricated in step (S30) is heated, for example, in a mixed gas atmosphere of hydrogen gas and propane gas under a pressure of $1 \times 10^3$ Pa at approximately 1500°C for 3 hours. Accordingly, the Si layer is supplied with carbon as a result of diffusion mainly from base substrate 10 and SiC substrate 20, thereby forming amorphous SiC layer 40 as shown in Fig. 14. In this way, silicon carbide substrate 1 can be manufactured in which SiC layer 20 is disposed while preventing defects in base layer 10 from being propagated thereto.

(Sixth Embodiment)

The following describes yet another embodiment of the present invention, i.e., a sixth embodiment. An IGBT 100 in the sixth embodiment has basically the same structure and provides basically the same effects as those of IGBT 100 in the first embodiment. However, IGBT 100 in the sixth embodiment is different from that of the first embodiment in terms of structure of silicon carbide substrate 1.

Specifically, referring to Fig. 16, silicon carbide substrate 1 in the sixth embodiment is different from that of the first embodiment in that an ohmic contact layer 50 is formed between base layer 10 and SiC layer 20. Ohmic contact layer 50 serves as an intermediate layer and is formed by siliciding at least a portion of a metal layer. Then, base layer 10 and SiC layer 20 are connected to each other by this ohmic contact layer 50. Ohmic contact layer 50 thus existing facilitates fabrication of silicon carbide substrate 1 in which SiC layer 20 is disposed while preventing defects in base layer 10 from being propagated thereto.

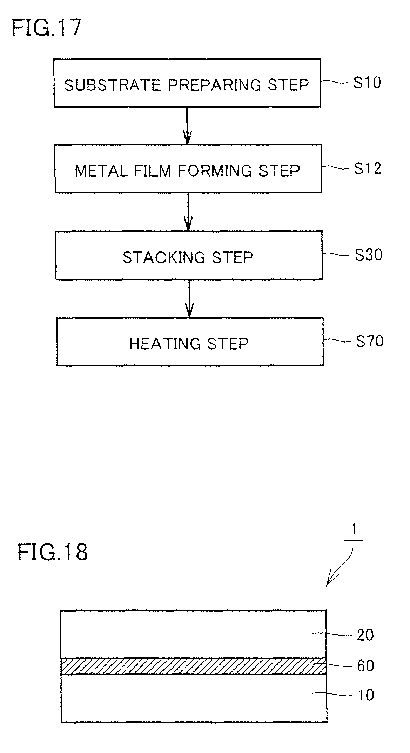

The following describes a method for manufacturing silicon carbide substrate 1 in the sixth embodiment. Referring to Fig. 17, in the method for manufacturing silicon carbide substrate 1 in the sixth embodiment, the substrate preparing step is performed as step (S10) in the same way as in the first embodiment, so as to prepare base substrate 10 and SiC substrate 20.

Next, a metal film forming step is performed as a step (S12). In this step (S12), a metal film is formed by, for example, depositing a metal on one main surface of base substrate 10 prepared in step (S10). This metal film contains, for example, a metal that forms silicide by heating, specifically, at least one of nickel, molybdenum, titanium, aluminum, and tungsten.

Next, a stacking step is performed as step (S30). In this step (S30), SiC substrate 20 prepared in step (S10) is placed on the metal film formed in step (S12). In this way, a stacked substrate is obtained in which SiC substrate 20 is provided over base substrate 10 with the metal film interposed therebetween.

Next, as a step (S70), a heating step is performed. In this step (S70), the stacked substrate fabricated in step (S30) is heated to approximately 1000°C in an inert gas atmosphere such as argon, for example. In this way, at least portions of the metal film (a region in contact with base substrate 10 and a region in contact with SiC substrate 20) are silicided, thereby forming ohmic contact layer 50, which makes ohmic contact with base layer 10 and SiC layer 20. Accordingly, silicon carbide substrate 1 can be readily manufactured in which SiC layer 20 is disposed while preventing defects in base layer 10 from being propagated thereto.

(Seventh Embodiment)

The following describes yet another embodiment of the present invention, i.e., a seventh embodiment. An IGBT 100 in the seventh embodiment has basically the same structure and provides basically the same effects as those of IGBT 100 in the first embodiment. However, IGBT 100 in the seventh embodiment is different from that of the first embodiment in terms of structure of silicon carbide substrate 1.

Specifically, referring to Fig. 18, silicon carbide substrate 1 of the seventh embodiment is different from that of the first embodiment in that a carbon layer 60 is formed between base layer 10 and SiC layer 20 as an intermediate layer. Then, base layer 10 and SiC layer 20 are connected to each other by this carbon layer 60. Carbon layer 60 thus existing facilitates fabrication of silicon carbide substrate 1 in which SiC layer 20 is disposed while preventing defects in base layer 10 from being propagated thereto.

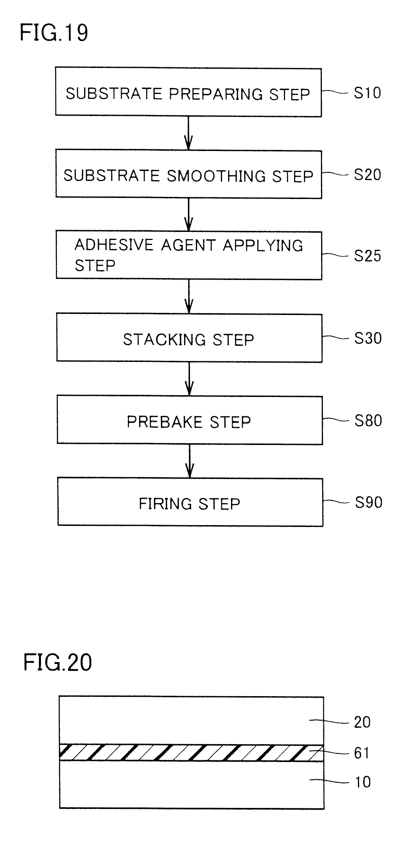

The following describes a method for manufacturing silicon carbide substrate 1 in the seventh embodiment. Referring to Fig. 19. first, step (S10) is performed in the same way as in the first embodiment, and then step (S20) is performed as required in the same way as in the first embodiment.

Next, as a step (S25), an adhesive agent applying step is performed. In this step (S25), referring to Fig. 20, for example, a carbon adhesive agent is applied to the main surface of base substrate 10, thereby forming a precursor layer 61. The carbon adhesive agent can be formed of, for example, a resin, graphite particles, and a solvent. Here, an exemplary resin usable is a resin formed into non-graphitizable carbon by heating, such as a phenol resin. An exemplary solvent usable is phenol, formaldehyde, ethanol, or the like. Further, the carbon adhesive agent is preferably applied at an amount of not less than 10 mg/cm$^2$ and not more than 40 mg/cm$^2$, more preferably, at an amount of not less than 20 mg/cm$^2$ and not more than 30 mg/cm$^2$ . Further, the carbon adhesive agent applied preferably has a thickness of not more than 100 $\mu$m, more preferably, not more than 50 $\mu$m.

Next, a stacking step is performed as step (S30). In this step (S30), referring to Fig. 20, SiC substrate 20 is placed on and in contact with precursor layer 61 formed on and in contact with the main surface of base substrate 10, thereby fabricating a stacked substrate.

Next, as a step (S80), a prebake step is performed. In this step (S80), the stacked substrate is heated, thereby removing the solvent component from the carbon adhesive agent constituting precursor layer 61. Specifically, for example, while applying a load to the stacked substrate in the thickness direction thereof, the stacked substrate is gradually heated to fall within a range of temperature exceeding the boiling point of the solvent component. Preferably, this heating is performed with base substrate 10 and SiC substrate 20 being pressed against each other using a clamp or the like. Further, by performing the prebaking (heating) as long as possible, the adhesive agent is degassed to improve strength in adhesion.

Next, as a step (S90), a firing step is performed. In this step (S90), the stacked substrate with precursor layer 61 heated and accordingly prebaked in step (S80) are heated to a high temperature, preferably, not less than 900°C and not more than 1100°C, for example, 1000°C for preferably not less than 10 minutes and not more than 10 hours, for example, for 1 hour, thereby firing precursor layer 61. Atmosphere employed upon the firing can be an inert gas atmosphere such as argon. The pressure of the atmosphere can be, for example, atmospheric pressure. In this way, precursor layer 61 is formed into carbon layer 60 made of carbon. As a result, referring to Fig. 18, silicon carbide substrate 1 of the seventh embodiment is obtained in which base substrate (base layer) 10 and SiC substrate (SiC layer) 20 are connected to each other by carbon layer 60.

It should be noted that in silicon carbide substrate 1, the crystal structure of silicon carbide constituting SiC layer 20 is preferably of hexagonal system, and is more preferably 4H-SiC. Further, base layer 10 and SiC layer 20 (as well as adjacent SiC layers 20 in the case where a plurality of SiC layers 20 are provided) are preferably made of silicon carbide single-crystal having the same crystal structure. In this way, by employing silicon carbide single-crystal of the same crystal structure for base layer 10 and SiC layer 20, physical properties such as a thermal expansion coefficient become the same therebetween, thereby preventing warpage of silicon carbide substrate 1, separation of base layer 10 and SiC layer 20, or separation of SiC layers 20 in the processes of manufacturing silicon carbide substrate 1 and manufacturing an IGBT using silicon carbide substrate 1.

Further, the silicon carbide single-crystals respectively constituting SiC layer 20 and base layer 10 (as well as adjacent SiC layers 20 in the case where a plurality of SiC layers 20 are provided) preferably have c axes forming an angle of less than 1°, more preferably, less than 0.1°. Further, it is preferable that the c planes of the respective silicon carbide single-crystals thereof are not rotated from each other in the plane.

Further, base layer (base substrate) 10 of silicon carbide substrate 1 used to manufacture the IGBT preferably has a diameter of 2 inches or greater, more preferably, 6 inches or greater. Furthermore, silicon carbide substrate 1 preferably has a thickness of not less than 200 $\mu$m and not more than 1000 $\mu$m, more preferably, not less than 300 $\mu$m and not more than 700 $\mu$m. Further, SiC layer 20 preferably has a resistivity of 50 mΩcm or smaller, more preferably, 20 mΩcm or smaller.

[Examples]

(Example 1)

The following describes an example 1. Calculation was made to estimate the effect of reducing the resistance of each silicon carbide substrate constituting the IGBT of the present invention. Specifically, the followings were calculated: a substrate resistance (total of respective resistances of base layer 10 and SiC layer 20) of silicon carbide substrate 1 corresponding to the foregoing first embodiment which included base layer 10 having a thickness of 200 $\mu$m and having a p type impurity density of $1 \times 10^{20}$ cm$^{-3}$, and SiC layer 20 having a thickness of 200 $\mu$m and having a p type impurity density of $1 \times 10^{18}$ cm$^{-3}$ (example A); and a resistance (substrate resistance) of base layer 10 corresponding to the foregoing second embodiment, having a thickness of 400 $\mu$m, and having a p type impurity density of $1 \times 10^{20}$ cm$^{-3}$ (example B). For comparison, there is also calculated a resistance (substrate resistance) of a silicon carbide substrate corresponding to a silicon carbide substrate constituting a conventional IGBT, having a thickness of 400 $\mu$m, and having a p type impurity density of $1 \times 10^{18}$ cm$^{-3}$ (comparative example A). The calculation was conducted in the following manner.

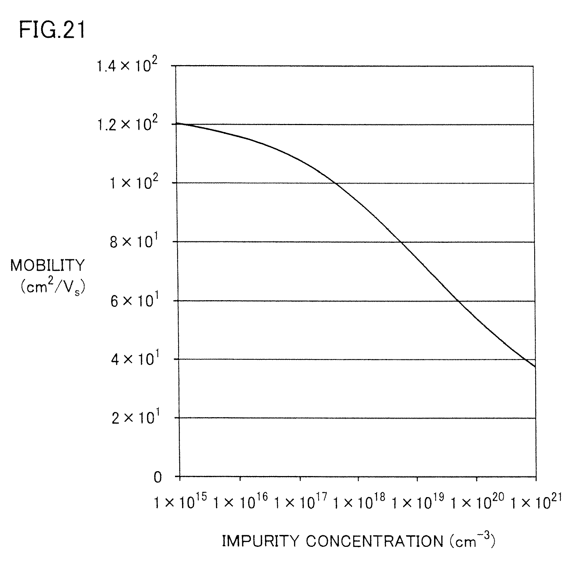

In the p type 4H-SiC, a relation shown in Fig. 21 is established between the impurity concentration (density) and the mobility. Further, resistance R of each substrate can be determined by the following formula. A result of the calculation is shown in Table 1.

[Formula 1]

$$R = \frac{W}{q \cdot p_{p0} \cdot \mu_{hole}}$$

[Table 1]

| | | Impurity Density (cm$^{-3}$) | Positive Hole Density (cm$^{-3}$) | Mobility (cm$^2$/Vs) | Thickness ($\mu$m) | Substrate Resistance (m$\Omega$cm$^2$) | |
|---|---|---|---|---|---|---|---|
| Example A | Base Layer | $1 \times 10^{20}$ | $1.1 \times 10^{18}$ | 94 | 200 | 0.24 | 1.34 |
| | SiC Layer | $1 \times 10^{18}$ | $1.1 \times 10^{17}$ | 108 | 200 | 1.1 | |
| Example B (Base Layer) | | $1 \times 10^{20}$ | $1.1 \times 10^{18}$ | 94 | 400 | 0.48 | |
| Comparative Example A | | $1 \times 10^{18}$ | $1.1 \times 10^{17}$ | 108 | 400 | 2.1 | |

As shown in Table 1, the substrate resistance of example A corresponding to the first embodiment can be reduced by approximately 36% as compared with comparative example A of the conventional one. Further, the substrate resistance of example B corresponding to the second embodiment can be reduced by approximately 77% as compared with comparative example A of the conventional one. Thus, it was confirmed that according to the IGBT of the present invention, the substrate resistance thereof can be reduced drastically as compared with the conventional one.

(Example 2)

The following describes an example 2. Calculation was made to estimate the effect of reducing contact resistance between the collector electrode (backside electrode) and the silicon carbide substrate in the IGBT of the present invention. Here, in order to reduce the contact resistance between the electrode that is a metal and the silicon carbide substrate that is a p type semiconductor and to attain ohmic contact therebetween, the following two approaches are contemplated:

(1) Employing a metal having a large work function $\phi$ to reduce Schottky barrier; and
(2) Increasing impurity density in the semiconductor to obtain a small depletion layer width, thereby obtaining a thin Schottky barrier.

However, actually, it is not easy to employ approach (1). It is effective to employ approach (2) so as to increase tunnel current, thereby attaining the ohmic contact. The following describes a result of the calculation regarding the contact resistance between the electrode and the base layer, assuming that the IGBT of the present invention employs a silicon carbide substrate including a base layer having a high impurity concentration.

For contact resistance $R_c$, the following formula is established:

[Formula 2]

$$Rc = (dJ/dV)^{-1} \ \ \Omega \cdot cm^2$$

$$Rc \propto \exp\left(\Phi_b / N_d^{1/2}\right)$$

$$Rc = \exp\left[(4m^{1/2}\varepsilon_s \times \Phi_{bn})/(N_d^{1/2} \times h)\right]$$

$$Rc \propto \exp\left(\Phi_{bn} / N_d^{1/2}\right)$$

Namely, contact resistance $R_c$ exponentially depends on $\Phi_{bn}/N_d^{1/2}$. By increasing impurity concentration (impurity density) $N_d$, contact resistance $R_c$ can be reduced. Specifically, the following were calculated: a contact resistance between a substrate (base layer), which has a p type impurity concentration of $1 \times 10^{20}$ cm$^{-3}$, and an electrode in one corresponding to the IGBT of the present invention (example C); and a contact resistance between a substrate, which has a p type impurity concentration of $1 \times 10^{18}$ cm$^{-3}$, and an electrode in one corresponding to a conventional IGBT (comparative example B). It should be noted that each of the electrodes can be made of a metal such as Al (aluminum). A result of the calculation is shown in Table 2.

[Table 2]

|  | Impurity Density (cm$^{-3}$) | Positive Hole Density (cm$^{-3}$) | Contact Resistance Ratio |
|---|---|---|---|
| Example C | $1 \times 10^{20}$ | $1.1 \times 10^{18}$ | 0.32 |
| Comparative Example B | $1 \times 10^{18}$ | $1.1 \times 10^{17}$ | 1 |

Referring to Table 2, the contact resistance in example C corresponding to the IGBT of the present invention is reduced by approximately 70% as compared with the contact resistance in comparative example B corresponding to the conventional IGBT. Thus, according to the IGBT of the present invention, the contact resistance can be significantly reduced between the substrate and the electrode (backside electrode). Generally, heat treatment is usually performed after formation of an electrode in order to reduce the contact resistance, but according to the IGBT of the present invention, the heat treatment may be omitted or the temperature of the heating treatment, which is normally approximately 1000°C, can be drastically decreased.

The embodiments and examples disclosed herein are illustrative and non-restrictive in any respect. The scope of the present invention is defined by the terms of the claims, rather than the embodiments described above, and is intended to include any modifications within the scope and meaning equivalent to the terms of the claims.

INDUSTRIAL APPLICABILITY

An IGBT of the present invention is advantageously applicable to a vertical type IGBT required to allow for reduced on-resistance.

REFERENCE SIGNS LIST

1: silicon carbide substrate; 2: buffer layer; 3: drift layer; 3A: main surface; 4: well region; 5: n$^+$ region; 6: p$^+$ region; 7: active layer; 10: base layer (base substrate); 10A: main surface; 10B: single-crystal layer; 11: material substrate; 11A: main surface; 20: SiC layer (SiC substrate); 20A, 20B: main surface; 20C: end surface; 40: amorphous SiC layer; 50: ohmic contact layer; 60: carbon layer; 61: precursor layer; 81: first heater; 82: second heater; 91: oxide film (gate oxide film); 92: emitter contact electrode; 93: gate electrode; 94: interlayer insulating film; 95: emitter wire; 96: collector electrode; 100: IGBT.

**Claims**

1. An insulated gate bipolar transistor (100) comprising:

    a silicon carbide substrate (1);
    a drift layer (3) made of single-crystal silicon carbide, disposed on/over one main surface of said silicon carbide substrate (1), and having n type conductivity;
    a well region (4) having p type conductivity and disposed to include a first main surface (3A) of said drift layer (3) opposite to said silicon carbide substrate (1);
    an emitter region (5) having n type conductivity and disposed to include said first main surface (3A) within said well region (4);
    an emitter electrode (92) disposed on said first main surface (3A) in contact with said emitter region (5);
    an insulating film (91) formed of an insulator and disposed on said first main surface (3A) in contact with said well region (4);
    a gate electrode (93) disposed on said insulating film (91); and
    a collector electrode (96) disposed on the other main surface of said silicon carbide substrate (1),
    said silicon carbide substrate (1) including
    a base layer (10) made of silicon carbide and having p type conductivity, and
    a SiC layer (20) made of single-crystal silicon carbide and disposed on said base layer (10),
    said base layer (10) having a p type impurity concentration exceeding $1 \times 10^{18}$ cm$^{-3}$.

2. The insulated gate bipolar transistor (100) according to claim 1, wherein said base layer (10) contains aluminum as an impurity introduced therein.

3. The insulated gate bipolar transistor (100) according to claim 1, wherein said SiC layer (20) has p type conductivity, and has an impurity concentration of not more than $1 \times 10^{18}$ cm$^{-3}$.

4. The insulated gate bipolar transistor (100) according to claim 1, wherein said SiC layer (20) has a main surface (20A) opposite to said base layer (10) and having an off angle of not less than 50° and not more than 65° relative to a {0001} plane.

5. The insulated gate bipolar transistor (100) according to claim 4, wherein the main surface (20A) of said SiC layer (20) opposite to said base layer (10) has an off orientation forming an angle of not more than 5° relative to a <1-100> direction.

6. The insulated gate bipolar transistor (100) according to claim 5, wherein the main surface (20A) of said SiC layer (20) opposite to said base layer (10) has an off angle of not less than -3° and not more than 5° relative to a {03-38} plane in the <1-100> direction.

7. The insulated gate bipolar transistor (100) according to claim 4, wherein the main surface (20A) of said SiC layer (20) opposite to said base layer (10) has an off orientation forming an angle of not more than 5° relative to a <11-20> direction.

8. The insulated gate bipolar transistor (100) according to claim 1, wherein:

   said silicon carbide substrate (1) further includes an intermediate layer (40, 50, 60) disposed between said base layer (10) and said SiC layer (20) and made of a conductor or a semiconductor, and
   said intermediate layer (40, 50, 60) connects said base layer (10) and said SiC layer (20) to each other.

9. The insulated gate bipolar transistor (100) according to claim 8, wherein said intermediate layer (50) is made of a metal.

10. The insulated gate bipolar transistor (100) according to claim 8, wherein said intermediate layer is made of carbon (60).

11. The insulated gate bipolar transistor (100) according to claim 8, wherein said intermediate layer is made of amorphous silicon carbide (40).

12. The insulated gate bipolar transistor (100) according to claim 1, wherein:

   said base layer (10) is made of single-crystal silicon carbide, and
   a half width of X-ray rocking curve of said SiC layer (20) is smaller than that of said base layer (10).

13. The insulated gate bipolar transistor (100) according to claim 1, wherein:

   said base layer (10) is made of single-crystal silicon carbide, and
   said SiC layer (20) has a micro pipe density lower than that of said base layer (10).

14. The insulated gate bipolar transistor (100) according to claim 1, wherein:

   said base layer (10) is made of single-crystal silicon carbide, and
   said SiC layer (20) has a dislocation density lower than that of said base layer (10).

15. The insulated gate bipolar transistor (100) according to claim 1, wherein said base layer (10) includes a single-crystal layer (1 0B made of single-crystal silicon carbide and including a main surface (10A) thereof facing said SiC layer (20).

FIG.1

FIG.2

## FIG.3

```
┌─────────────────────────────┐
│ SILICON CARBIDE SUBSTRATE   │── S110
│ PREPARING STEP              │
└─────────────────────────────┘
              │
              ▼
┌─────────────────────────────┐
│    EPITAXIAL GROWTH STEP    │── S120
└─────────────────────────────┘
              │
              ▼
┌─────────────────────────────┐
│    ION IMPLANTATION STEP    │── S130
└─────────────────────────────┘
              │
              ▼
┌─────────────────────────────┐
│  ACTIVATION ANNEALING STEP  │── S140
└─────────────────────────────┘
              │
              ▼
┌─────────────────────────────┐
│   OXIDE FILM FORMING STEP   │── S150
└─────────────────────────────┘
              │
              ▼
┌─────────────────────────────┐
│   ELECTRODE FORMING STEP    │── S160
└─────────────────────────────┘
```

## FIG.4

FIG.5

FIG.6

FIG.7

```
┌─────────────────────────────┐
│   SUBSTRATE PREPARING STEP   │ ── S10
└─────────────────────────────┘
              │
              ▼
┌─────────────────────────────┐
│  SUBSTRATE SMOOTHING STEP    │ ── S20
└─────────────────────────────┘
              │
              ▼
┌─────────────────────────────┐
│        STACKING STEP         │ ── S30
└─────────────────────────────┘
              │
              ▼
┌─────────────────────────────┐
│       CONNECTING STEP        │ ── S40
└─────────────────────────────┘
```

FIG.8

## FIG.9

SUBSTRATE PREPARING STEP — S10

↓

CLOSELY ARRANGING STEP — S50

↓

SUBLIMATION STEP — S60

## FIG.10

## FIG.11

FIG.12

FIG.13

FIG.14

FIG.15

```
┌─────────────────────────────┐
│  SUBSTRATE PREPARING STEP   │── S10
└─────────────────────────────┘
              │
              ▼
┌─────────────────────────────┐
│     Si LAYER FORMING STEP   │── S11
└─────────────────────────────┘
              │
              ▼
┌─────────────────────────────┐
│       STACKING STEP         │── S30
└─────────────────────────────┘
              │
              ▼
┌─────────────────────────────┐
│        HEATING STEP         │── S70
└─────────────────────────────┘
```

FIG.16

FIG.17

```
┌─────────────────────────────────┐
│   SUBSTRATE PREPARING STEP      │──── S10
└─────────────────────────────────┘
                │
                ▼
┌─────────────────────────────────┐
│     METAL FILM FORMING STEP     │──── S12
└─────────────────────────────────┘
                │
                ▼
┌─────────────────────────────────┐
│         STACKING STEP           │──── S30
└─────────────────────────────────┘
                │
                ▼
┌─────────────────────────────────┐
│         HEATING STEP            │──── S70
└─────────────────────────────────┘
```

FIG.18

FIG.19

```
┌─────────────────────────────┐
│  SUBSTRATE PREPARING STEP   │ ── S10
└─────────────────────────────┘
              │
              ▼
┌─────────────────────────────┐
│  SUBSTRATE SMOOTHING STEP   │ ── S20
└─────────────────────────────┘
              │
              ▼
┌─────────────────────────────┐
│  ADHESIVE AGENT APPLYING    │ ── S25
│  STEP                       │
└─────────────────────────────┘
              │
              ▼
┌─────────────────────────────┐
│       STACKING STEP         │ ── S30
└─────────────────────────────┘
              │
              ▼
┌─────────────────────────────┐
│       PREBAKE STEP          │ ── S80
└─────────────────────────────┘
              │
              ▼
┌─────────────────────────────┐
│       FIRING STEP           │ ── S90
└─────────────────────────────┘
```

FIG.20

FIG.21

MOBILITY $(cm^2/V_s)$

IMPURITY CONCENTRATION $(cm^{-3})$

## INTERNATIONAL SEARCH REPORT

| | International application No. |
|---|---|
| | PCT/JP2010/057445 |

**A. CLASSIFICATION OF SUBJECT MATTER**
*H01L29/739*(2006.01)i, *H01L21/02*(2006.01)i, *H01L21/20*(2006.01)i, *H01L21/336*(2006.01)i, *H01L29/12*(2006.01)i, *H01L29/78*(2006.01)i

According to International Patent Classification (IPC) or to both national classification and IPC

**B. FIELDS SEARCHED**

Minimum documentation searched (classification system followed by classification symbols)
H01L29/739, H01L21/02, H01L21/20, H01L21/336, H01L29/12, H01L29/78

Documentation searched other than minimum documentation to the extent that such documents are included in the fields searched
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | WO 2008/111269 A1 (Sumitomo Electric Industries, Ltd.), 18 September 2008 (18.09.2008), paragraphs [0035] to [0055]; fig. 1 to 11 & JP 2008-226997 A | 1,2,4-7,15<br>3,8-14 |
| Y | JP 2006-228961 A (Toyota Central Research and Development Laboratories, Inc.), 31 August 2006 (31.08.2006), paragraphs [0013] to [0014]; fig. 1 (Family: none) | 3 |
| Y | WO 2006/114999 A1 (Kyoto University), 02 November 2006 (02.11.2006), paragraph [0062] & US 2009/0072243 A1 | 8-11 |

| [×] | Further documents are listed in the continuation of Box C. | [ ] | See patent family annex. |
|---|---|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 26 July, 2010 (26.07.10) | 03 August, 2010 (03.08.10) |

| Name and mailing address of the ISA/<br>Japanese Patent Office | Authorized officer |
|---|---|
| Facsimile No. | Telephone No. |

Form PCT/ISA/210 (second sheet) (July 2009)

**INTERNATIONAL SEARCH REPORT**

| International application No. |
| --- |
| PCT/JP2010/057445 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | WO 01/018872 A1  (Sixon Inc.),<br>15 March 2001 (15.03.2001),<br>page 7, line 1 to page 26, line 24; fig. 1<br>to 11<br>& JP 3854508 B          & EP 1215730 A1<br>& DE 60033829 T          & TW 565630 B | 12-14 |
| A | JP 2002-280531 A  (Denso Corp.),<br>27 September 2002 (27.09.2002),<br>paragraphs [0005] to [0007]; fig. 5, 6<br>(Family: none) | 1-15 |
| A | JP 11-003842 A  (Nippon Pillar Packing Co.,<br>Ltd.),<br>06 January 1999 (06.01.1999),<br>paragraphs [0012] to [0021]; fig. 1 to 4<br>(Family: none) | 1-15 |
| A | JP 11-087200 A  (Toshiba Corp.),<br>30 March 1999 (30.03.1999),<br>paragraphs [0021] to [0023]; fig. 6<br>(Family: none) | 1-15 |
| A | JP 10-223835 A  (Hitachi, Ltd.),<br>21 August 1998 (21.08.1998),<br>paragraphs [0013] to [0068]; fig. 1 to 14<br>(Family: none) | 1-15 |

Form PCT/ISA/210 (continuation of second sheet) (July 2009)

## INTERNATIONAL SEARCH REPORT

International application No.

PCT/JP2010/057445

| Box No. II | Observations where certain claims were found unsearchable (Continuation of item 2 of first sheet) |

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

| Box No. III | Observations where unity of invention is lacking (Continuation of item 3 of first sheet) |

This International Searching Authority found multiple inventions in this international application, as follows:
   See extra sheet

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**
☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**INTERNATIONAL SEARCH REPORT**

International application No.

PCT/JP2010/057445

Continuation of Box No.III of continuation of first sheet(2)

The inventions in claims 1-15 are common in having the same or corresponding technical feature wherein "a silicon carbide substrate (1), a drift layer (3), which is composed of single crystal silicon carbide, is disposed on one main surface of the silicon carbide substrate (1) and has n-type conductivity, a well region (4), which is disposed on the drift layer (3) such that the well region includes a first main surface (3A) on the opposite side to the silicon carbide substrate (1) and has p-type conductivity, an emitter region (5), which is disposed so as to include the first main surface (3A) in the well region (4) and has n-type conductivity, an emitter electrode (92), which is disposed on the first main surface (3A) such that the emitter electrode is in contact with the emitter region (5), an insulating film (91), which is composed of an insulating body and is disposed on the first main surface (3A) such that the insulating film is in contact with the well region (4), and a gate electrode (93) disposed on the insulating film (91), and a collector electrode (96) disposed on the other main surface of the silicon carbide substrate (1) are provided, the silicon carbide substrate (1) includes a base layer (10), which is composed of silicon carbide and has p-type conductivity, and a SiC layer (20), which is composed of single crystal silicon carbide and is disposed on the base layer (10), and the p-type impurity concentration of the base layer (10) exceeds $1 \times 10^{18} \text{cm}^{-3}$".

This technical feature, however, is publicly known as disclosed in WO 2008/111269 A1, paragraphs [0035]-[0055], fig. 1-11.

Therefore, there is no technical relationship expressed by the same or corresponding special technical feature between the inventions in claims 1-15.

Consequently, the inventions in claims 1-15 are not a group of inventions so linked as to form a single general inventive concept.

Form PCT/ISA/210 (extra sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **R. C. GLASS et al.** SiC Seeded Crystal Growth. *Phys. stat. sol. (b),* 1997, vol. 202, 149-162

- **R. C. GLASS et al.** SiC Seeded Crystal Growth. *Phys. stat. sol.(b),* 1997, vol. 202, 149-162